Europäisches Patentamt

European Patent Office

Office européen des brevets

(11) Publication number: **0 070 086**
**B1**

(12) **EUROPEAN PATENT SPECIFICATION**

(45) Date of publication of patent specification: **09.08.89**

(51) Int. Cl.⁴: **H 03 M 1/10, H 03 M 1/66**

(21) Application number: **82302355.1**

(22) Date cf filing: **07.05.82**

(54) **Digital-to-analogue converter which can be calibrated automatically.**

(30) Priority: **07.05.81 GB 8113886**
**07.05.81 GB 8113887**
**07.05.81 GB 8113888**

(43) Date of publication of application:
**19.01.83 Bulletin 83/03**

(45) Publication of the grant of the patent:
**09.08.89 Bulletin 89/32**

(84) Designated Contracting States:
**DE FR GB NL SE**

(56) References cited:
**EP-A-0 061 199**
**DE-A-3 003 099**
**FR-A-2 254 913**
**FR-A-2 386 939**
**FR-A-2 404 957**
**FR-A-2 447 119**
**US-A-3 651 517**
**US-A-4 222 107**
**ELECTRO/81 CONFERENCE RECORD, vol. 6,**
**April 7-9, 1981, pages 1-8, New York, US, P.**
**PRAZAK: "Digital techniques preserve D/A**
**accuracy over time and temperature"**

(73) Proprietor: **CAMBRIDGE CONSULTANTS**
**LIMITED**
**Science Park Milton Road**
**Cambridge CB4 4DW (GB)**

(72) Inventor: **Davies, Christopher**
**62 Foxhollow Bar Hill**
**Cambridge (GB)**
Inventor: **Storey, Michael John**
**162 Sturton Street**
**Cambridge (GB)**

(74) Representative: **Beresford, Keith Denis Lewis**
**et al**
**BERESFORD & Co. 2-5 Warwick Court High**
**Holborn**
**London WC1R 5DJ (GB)**

Courier Press, Leamington Spa, England.

## Description

This invention relates to a digital-to-analogue converter which can be calibrated automatically and which has a plurality of weighted current sources, selection means connected to one end of said weighted current sources and responsive to a digital word to be converted to analogue form for selecting said weighted current sources, summing means for summing the currents from the selected weighted current sources to provide an analogue output signal representing the digital word, and calibration means coupled to at least two of said weighted current sources and arranged for performing a calibration operation in which said at least two sources may be selected to provide a measurable current, the measurable current is measured and a correction is made to compensate at least partly for any errors in the measurable current.

The reason for the inclusion of the calibration means is that errors in the currents output by the current sources arise, for example due to drift in the value of reference resistors as a consequence of changes in operating temperature. The best (technologically realistic) resistors currently available have temperature tracking coefficients of the order of 1 ppm per °C. A DAC specified as operable over a range of 50°C would therefore, unless provision is made for correction, be limited to 14 bit accuracy using such resistors. The temperature of a DAC capable of 20 bit accuracy would need to be controlled to better than 1°C without provision for correction.

A digital-to-analogue converter of the type to which the invention relates is disclosed in US Patent 4,222,107. In this patent, the calibration operation involves discontinuing the supply of digital words to be converted to analogue form and instead applying known digital words to the selection means. The calibration means then applies corrections dependent upon detection of errors in the analogue signal produced by the application of the known digital words during the calibration operation. This system requires that the operation of the device has to be interrupted periodically in order to enable calibration to be performed.

The problem underlying the invention is to provide a digital-to-analogue converter in which this problem is overcome.

The digital-to-analogue converter according to the invention is characterised by second selection means connected to said at least two weighted current sources and controlled by said calibration means to provide said measurable current independently of operation of the first-mentioned selection means so that calibration may be performed without interrupting the digital-to-analogue conversion.

In a preferred embodiment, said second selection means is connected to said at least two weighted current sources at the ends thereof opposite to said one end to which the first-mentioned selection means is connected, and

means is connected to each of said at least two weighted current sources to maintain the currents provided thereby substantially invariant irrespective of selection thereof by either one or both of said selection means.

The invention is described further by way of example with reference to the accompanying drawings in which:

Fig. 1 is a diagram of a circuit including a digital-to-analogue converter in accordance with an embodiment of the present invention;

Fig. 2 shows in more detail part of the circuit shown in Fig. 1;

Fig. 3 is a waveform diagram illustrating operation of the part of the circuit shown in Fig. 2;

Fig. 4 is a diagram similar to Fig. 1, showing a further embodiment of the invention;

Fig. 5 illustrates a first form of analogue-to-digital converter including a digital to analogue converter according to the present invention;

Fig. 6 illustrates a second form of analogue-to-digital converter which includes a digital-to-analogue converter in accordance with the present invention; and

Fig. 7 illustrates a third form of analogue-to-digital converter which includes a digital-to-analogue converter in accordance with the present invention.

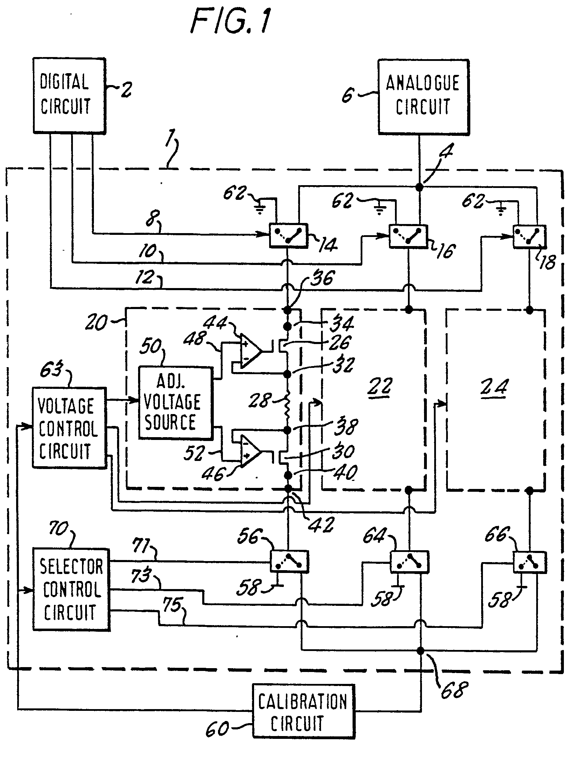

With reference to Fig. 1a digital-to-analogue converter 1 receives from a digital circuit 2 digital words which are to be converted to an analogue signal at summing junction 4 of the converter for supply to an analogue circuit 6. For simplicity, Fig. 1 only shows the circuitry for converting three bits of the digital words produced by circuit 2 to analogue form. These three bits are provided by circuit 2 to lines 8, 10 and 12 which are connected to selector circuits 14, 16 and 18 respectively so that, when a digital 1 appears on a line 8, 10 or 12, the associated selector circuit 14, 16 or 18 supplies to the summing junction 4 a current, weighted according to the significance of the bit, from an associated current regulator 20, 22 or 24.

Current regulator 20 comprises an n-channel FET 26, a resistor 28 and a p-channel FET 30 all connected in series. The FET 26 has its source 32 and drain 34 connected respectively to the resistor 28 and a terminal 36; and the FET 30 has its source 38 connected to resistor 28 and its drain 40 connected to terminal 42. The FET's 26 and 30 may be j-FET's or MOSFET's.

Accordingly, current may flow from the terminal 36 to the terminal 42 under control of the FET's 26 and 30. For effecting this control, operational amplifiers 44 and 46 are provided. These are preferably low input bias current operational amplifiers or low input bias current transconductance amplifiers. These amplifiers and the FETs 26 and 30 are characterised by low bias leakage currents. Amplifier 44 has its output connected to the gate of FET 26, its negative input connected to the source 32 of FET 26 and its positive input connected to one terminal 48 of an adjustable DC voltage source 50. The amplifier 46 has its output connected to the gate of FET 30, its negative input connected to the source 38 of FET 30 and its positive input connected to the other terminal 52 of adjustable voltage source 50 which thus applies, between the positive inputs of the amplifiers 44 and 46, a DC voltage whose magnitude can be adjusted by adjustment of the source 50.

Terminal 42 is connectable, via a selector circuit 56 to either a current sink 58, at a negative voltage, or to a calibration circuit 60. The arrangement of the FETs 26 and 30 and amplifiers 44 and 46 in the current regulator 20 is such that the current flowing between terminals 36 and 42 remains invariant irrespective of whether the selector 14 connects terminal 36 to the summing junction 4 or to a ground connection 62 and irrespective of whether selector 56 connects terminal 42 to the current sink or to the calibrator 60. With the arrangement shown, the current flowing from terminal 42 is substantially equal to that flowing into terminal 36 from the summing junction 4 since there is little current loss in the FETs 26 and 30 and little current flow into the negative inputs of the amplifiers 44 and 46. With properly chosen low bias current amplifiers and low leakage current FETs, the loss may be as low as 1 part in $10^8$. Measurement of the current flowing out of the terminal 42 therefore provides an accurate measure of the current flowing from the summing junction 4 to the terminal 36 and since these currents remain constant regardless of the condition of the selectors 14 and 56, this measurement can be made at any time, i.e. without interruption of the digital to analogue conversion, by connecting the terminal 42 to the calibration circuit 60 via the selector 56. Accordingly such measurements can be periodically made and in the event of variation in the measured current due, for example, to drift of the resistor 28, the current can be corrected by changing the voltage applied by the voltage source 50 between the positive inputs of the amplifiers 44 and 46. This voltage change is achieved by a control device 63 which generates a correction voltage in response to a signal from the calibration circuit 60.

It will be apparent that whenever the selector 14 or 56 is changed over from one of its conditions to its other condition, a change in the impedance of the circuit connected to the terminal 36 or 42 will take place. The FET's 26 and 30 and their associated circuitry isolate the current flowing through the resistor 28 from the effects of these changes in impedance by compensating for the impedance changes. The current through the resistor 28 is thereby prevented from varying. Thus, the FET's 26 and 30, amplifiers 44 and 46 and reference voltage source 50 operate to maintain a constant voltage across the resistor 28. This voltage is substantially equal to the reference voltage in the arrangement shown in Fig. 1 and is adjustable, as indicated, to compensate for variations in the value of resistor 28.

Although current regulators 22 and 24 are not shown in detail, their construction is identical to that of current regulator 20 except that the resistors 28 of the current regulators 20, 22 and 24 are weighted to provide the required weighted currents to the summing junction 4. Thus, the resistor 28 (not shown) of voltage regulator 22 should have a resistance value as close as possible to twice that of the resistor 28 of current regulator 20 and the resistor 28 (not shown) of current regulator 24 should have a value as close as possible to twice that of the resistor 28 (not shown) of current regulator 22. As a result, the current regulator 20 provides the current corresponding to the most significant bit of the digital word from circuit 2 and current regulators 22 and 24 provide currents corresponding to the next two bits of lower significance. Although only three current regulators are shown in Fig. 1 there will normally be N current regulators for an N bit digital-to-analogue converter although the regulators corresponding to the bits of low significance need not be of the construction shown.

The current regulators 22 and 24 are also connectable, via selectors 64 and 66 to either the current sink 58 or the calibration circuit 60, the latter via a summing junction 68 to which the selector 56 is also connected. The selectors 56, 64 and 66 are controlled by a control circuit 70 in response to instructions from the calibration circuit 60.

The embodiment of Figs. 1 to 3 is operated in accordance with a calibration routine which causes numerous measurements of relative magnitudes of the current to be taken in one measurement cycle. Adjustments of the current regulators are then carried out in accordance with the average values obtained.

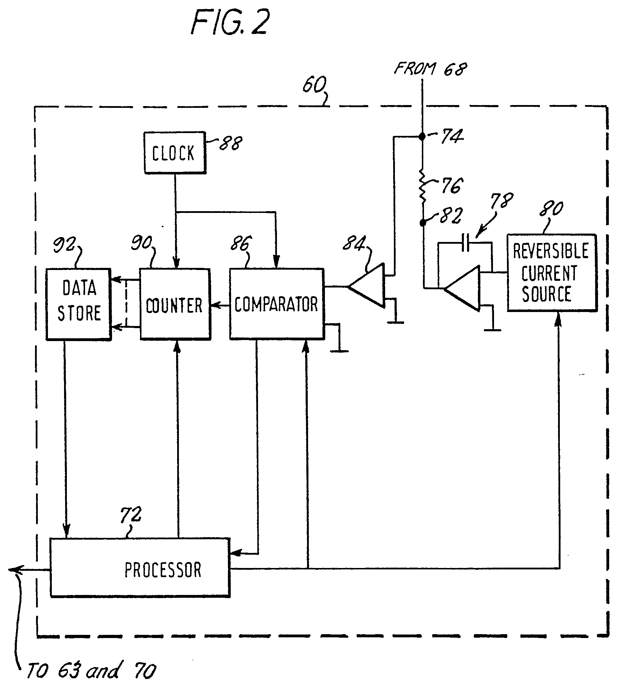

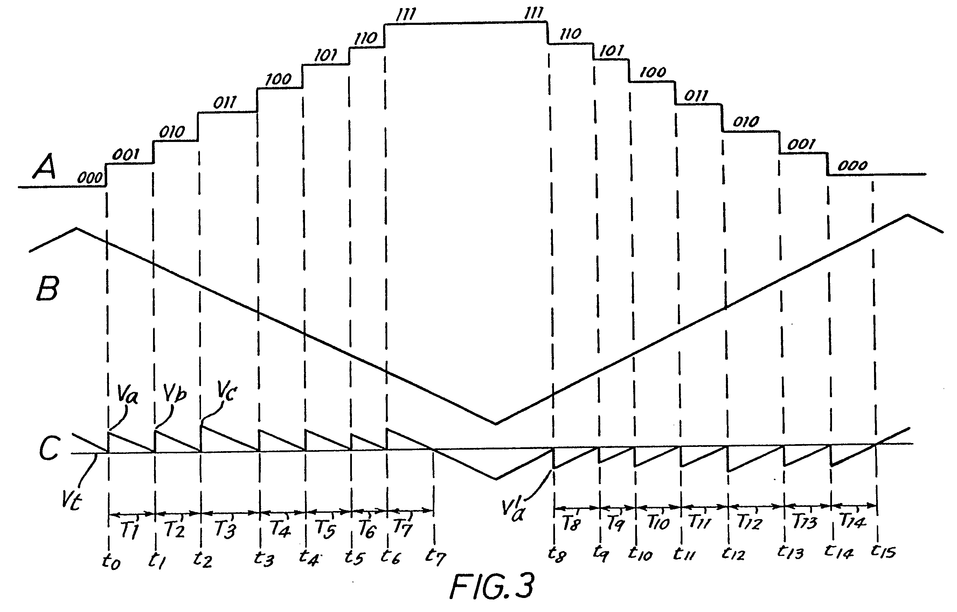

With particular reference to Figs. 2 and 3, the calibration circuit 60 includes a processor 72 which controls the circuit 70 to output, on its output lines 71, 73 and 75 which are connected respectively to the selectors 56, 64 and 66, a binary number. At the start of a calibration routine this is set at 000 and is then successively incremented by unity so that the current supplied to the calibration circuit 60 via the summing junction 68 successively represents the numbers in the sequence 000, 001, 010, . . ., 111. After the number has reached the value 111, it is successively decremented by unity so that the current flowing from the summing junction 68 to the calibration circuit 60 is successively reduced through values representing the succession of binary numbers 111, 110, . . ., 000. This stepwise increase and decrease in this current is illustrated in waveform A of Fig. 3 which shows that the current is of staircase waveform. The staircase waveform current of Fig. 3A is applied to one terminal 74 at one end of a resistor 76 included in the calibration circuit. The other end of the resistor 76 is connected to an integrator 78 having its input connected to a reversible current source 80. The processor 72 controls the current source 80 so that, while the staircase waveform of Fig. 3 is increasing, a decreasing ramp voltage appears at the terminal 82 of resistor 76 and, when the staircase waveform of Fig. 3 is decreasing, an increasing ramp voltage appears at terminal 82. These ramp voltages are illustrated in waveform B of Fig. 3. As a consequence, the voltage appearing at terminal 74 of resistor 76 is, as shown in waveform C of Fig. 3, of sawtooth form representing

3

effectively the sum of waveforms (A) and (B) of Fig 3. The waveform (C) of Fig. 3 is amplified and clipped in a circuit 84. The output of the circuit 84 is applied to a comparator circuit 86.

The increasing and decreasing ramp voltage of waveform B of Fig. 3 is continuously generated. Prior to the beginning of each measuring routine, as previously indicated, the number output by circuit 70 is 000 and this number is output during a time when the ramp voltage is near its maximum. The measuring routine begins at time $t_0$ when the voltage at terminal 74 falls to a threshold value $V_t$. This is detected by the comparator circuit 86. In response to this detection, the number in a counter 90, which counts pulses from a clock 88, is stored in a data store 92 under control of the processor 72 which also causes the circuit 70 to output 001 at time $t_0$. The current flowing from the summing junction 68 to the calibration circuit 60 steps up from zero to a value equal to that flowing through current regulator 24 so that the voltage at terminal 74 steps up by a value indicated in waveform C of Fig. 3 as $V_a$, which is proportional to the current through regulator 24. Due to the ramp generated by the integrator 78 and current source 80, the voltage at terminal 74 decreases at a rate equal to the slope of the ramp and at time $t_1$ again reaches the level $V_t$. The time from $t_0$ to $t_1$ taken for the voltage at terminal 74 to decrease to $V_t$ is a measure of the magnitude of voltage step $V_a$ and therefore a measure of the current flowing through the current regulator 24. The comparator circuit 86 detects the arrival of the voltage at the threshold level $V_t$ at $t_1$. At this time processor 72, in response to the signal from the comparator circuit 86, again transfers the number in counter 90 into the data store 92, and again causes the circuit 70 to increment by unity the number output on lines 71, 73 and 75 to 010 so that the summing junction 68 receives current from current regulator 22 which, if the circuit is correctly calibrated, will be twice the current flowing through regulator 24. Accordingly, the voltage at terminal 74 is again stepped up, this time by a value $V_b$ which is dependent on the current flowing through the regulator 22. The voltage at terminal 74 again descends through the value $V_b$ at a rate determined by the voltage gradient at terminal 82 and reaches the threshold level $V_t$ again at time $t_2$. At $t_2$ the processor 72 again transfers the count from counter 90 to data store 92 and again increments by unity the number output by circuit 70 to a value 011. This then causes the summing junction 68 to supply to the calibration circuit 60 a current equal to the sum of the currents through the regulators 22 and 24 so that at time $t_2$, the voltage at terminal 74 is increased by a value $V_c$ dependent upon the sum of the currents through the regulators 22 and 24. The process continues as shown in Fig. 3 until the data store 90 has stored the values which were in counter 90 at each of the times $t_0$ to $t_7$. Thereafter the processor 72 changes the polarity of the current source 80, decrements by unity the number output by the circuit 70 so that at time $t_8$ the voltage at terminal 74 steps down by a value $V'_a$ and then rises in accordance with the positive going ramp generated by the integrator 78. The processor, when changing the polarity of current source 80 also switches the comparator circuit 86 to a condition to detect when the rising voltage of waveform (C) of Fig. 3 reaches the threshold level $V_t$. Each time the voltage at terminal 74 reaches the threshold level $V_t$, the processor 72 stores the number in counter 90 in data store 92 and decrements by unity the number output by the circuit 70. Accordingly, after the binary number output by the circuit 70 has been decremented to 000 the data store contains the values which were in counter 90 at each of times $t_0$ to $t_{15}$. From this data, the periods $T_1$ to $T_{14}$ between $t_0$ and $t_1$, $t_1$ and $t_2$ etc. can be calculated. If the currents flowing through each of the current regulators 20, 22 and 24 are respectively $i_1$, $i_2$ and $i_3$ then the following Table I illustrates the current flowing from the summing junction 68 to the calibration circuit 60 in each of the time periods $T_1$ to $T_{14}$:

TABLE I

| Interval | Sum currents flowing to calibration circuit 60 |
|:---:|:---:|
| $T_1$ | $0+0+i_3$ |
| $T_2$ | $0+i_2+0$ |
| $T_3$ | $0+i_2+i_3$ |
| $T_4$ | $i_1+0+0$ |
| $T_5$ | $i_1+0+i_3$ |
| $T_6$ | $i_1+i_2+0$ |
| $T_7$ | $i_1+i_2+i_3$ |
| $T_8$ | $i_1+i_2+0$ |
| $T_9$ | $i_1+0+i_3$ |
| $T_{10}$ | $i_1+0+0$ |
| $T_{11}$ | $0+i_2+i_3$ |
| $T_{12}$ | $0+i_2+0$ |
| $T_{13}$ | $0+0+i_3$ |
| $T_{14}$ | $0+0+0$ |

The length of each of time periods $T_1$ to $T_{14}$ is a measure of the difference between the current which flows during any given time period and that which flowed during the preceding time period. Accordingly, the values represented by the length of the time periods are shown in Table II:

4

TABLE II

| Interval | Currents represented thereby |
|---|---|
| $T_1$ | $i_3$ |
| $T_2$ | $i_2 - i_3$ |
| $T_3$ | $i_3$ |
| $T_4$ | $i_1 - (i_2 + i_3)$ |
| $T_5$ | $i_3$ |
| $T_6$ | $i_2 - i_3$ |
| $T_7$ | $i_3$ |
| $T_8$ | $i_3$ |
| $T_9$ | $i_2 - i_3$ |
| $T_{10}$ | $i_3$ |
| $T_{11}$ | $i_1 - (i_2 + i_3)$ |
| $T_{12}$ | $i_3$ |
| $T_{13}$ | $i_2 - i_3$ |
| $T_{14}$ | $i_3$ |

It follows that eight values for each of the currents $i_1$, $i_2$, $i_3$ may be obtained from the computations carried out on the different time periods $T_1$ to $T_{14}$, as shown in Table III:

TABLE III

| Current | Measure of current given by: |
|---|---|
| $i_1$ | $T_1 + T_2 + T_3 + T_4$ |
| | $T_2 + T_3 + T_4 + T_5$ |
| | $T_3 + T_4 + T_5 + T_6$ |
| | $T_4 + T_5 + T_6 + T_7$ |
| | $T_8 + T_9 + T_{10} + T_{11}$ |
| | $T_9 + T_{10} + T_{11} + T_{12}$ |
| | $T_{10} + T_{11} + T_{12} + T_{13}$ |
| | $T_{11} + T_{12} + T_{13} + T_{14}$ |
| $i_2$ | $T_1 + T_2$ |
| | $T_2 + T_3$ |
| | $T_5 + T_6$ |
| | $T_6 + T_7$ |
| | $T_8 + T_9$ |
| | $T_9 + T_{10}$ |
| | $T_{12} + T_{13}$ |
| | $T_{13} + T_{14}$ |
| $i_3$ | $T_1$ |
| | $T_3$ |
| | $T_5$ |
| | $T_7$ |
| | $T_8$ |
| | $T_{10}$ |
| | $T_{12}$ |
| | $T_{14}$ |

As previously indicated, for proper operation of the digital-to-analogue converter, the following relationship should hold:

$$i_1 = 2i_2$$
$$i_2 = 2i_3$$

The processor computes a number of values for each of $i_1$, $i_2$ and $i_3$ from the equations shown in the

5

above table, averages the values for each of the currents, and determines the correction necessary to ensure that the above relationships between $i_1$, $i_2$ and $i_3$ are satisfied. Appropriate signals are then transmitted to the voltage control circuit 63 which in turn controls the current regulators 20, 22 and 24.

It should be noted that although the curve (B) of Fig. 3 has been shown as a straight line, in practice there will be some non-linearity. When the curve is falling, as during the time from $t_0$ to $t_7$ this non-linearity will result in errors of one sense in the time periods $t_1$ to $t_7$ whereas when the ramp voltage of curve (B) is rising, as during the period from time $t_8$ to time $t_{14}$ the non-linearity of the ramp voltage will be such that errors in periods $T_8$ to $T_{14}$ are of the opposite sense. Thus, this non-linearity is compensated for by carrying out the process illustrated in Fig. 3.

The calibration current described measures time intervals and computes the relative magnitudes of the currents in the DAC. These enable the linearity of the DAC to be known and controlled. By introducing an independent calibrated current source, such as a secondary standard, and measuring this current at the same time the accuracy as well as the linearity of the DAC can be controlled.

The circuit is arranged so that the voltages and ramp slope are the same in each rising and falling period of the calibration, so that the voltage offsets in the amplifiers and the delays in the amplifier 84 and comparator 86 are identical and result in a constant shift in count values. Such errors do not therefore influence the computed currents.

The DAC in the above example contains N=3 current regulators, and each current is derived from the averaging of eight time periods. In general in an N-bit DAC, the greater the number of bits precision, the more information is obtained in the above calibration routine to estimate each current. In each calibration period the average of each current is derived from $2^N$ count values.

Noise is a significant factor in the manufacture of current ratios of a DAC particularly when more than 20 bits resolution is sought. The averaging of $2^N$ values has the effect of reducing noise in the current estimate in a calibration period by a factor of $\sqrt{2^N}$. In the present calibration routine, if N=20 noise is lowered by about a thousand times compared with its magnitude when each current is measured only once.

The calibration circuit can be employed in a DAC, whether the ratio of adjacent currents is exactly 2:1 or whether the ratios are allowed to depart from 2.

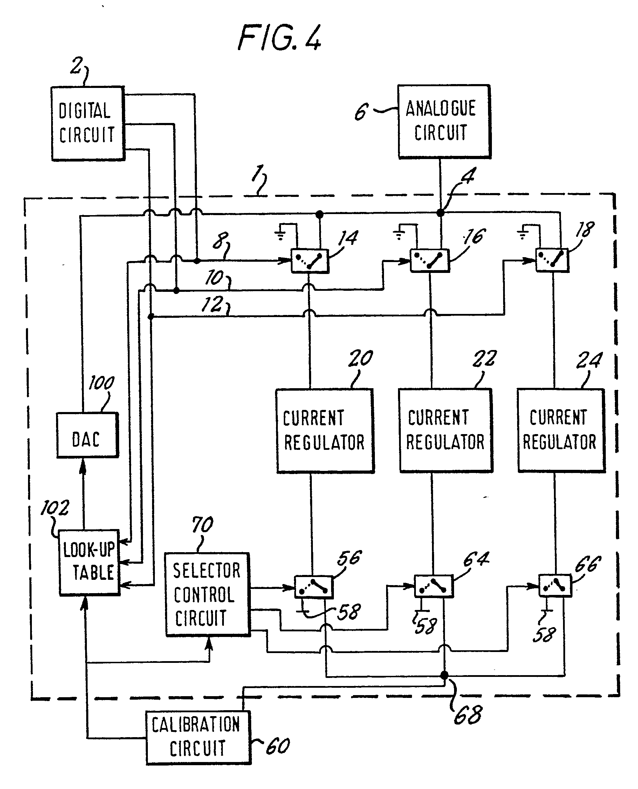

In Fig. 4, the reference numbers which correspond to those shown in Fig. 1 illustrate corresponding elements. However this embodiment differs from that of Figs. 1 to 3 in that when errors in the currents $i_1$, $i_2$ and $i_3$ are detected by the calibration circuit, an auxiliary digital-to-analogue converter 100 generates an analogue correction signal which is applied to summing junction 4 in order to correct the error, instead of making separate adjustments in the current regulators 20, 22 and 24. Accordingly, the voltage control circuit 63 of Fig. 1 is omitted and the adjustable voltage sources 50 of the regulators 20, 22 and 24 are pre-set. The magnitude of the analogue correction signal required depends not only upon the errors in the currents $i_1$, $i_2$ and $i_3$ but also upon the digital word output by the circuit 2. Accordingly, this word is applied to a look up table 102 which also receives a digital correction signal from the calibration circuit 60. The look up table 102 generates a digital output, converted to analogue form in the digital to analogue converter 100, in dependence upon the word output by the digital circuit 2 and the error signal output by the calibration circuit 60.

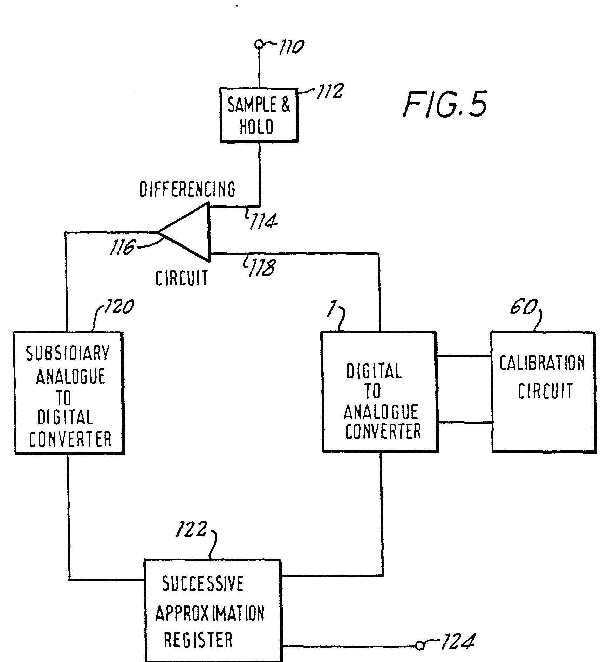

Fig. 5 illustrates an embodiment of the invention in an analogue-to-digital converter. The analogue signal to be converted to digital form is applied to an analogue input terminal 110 and stored in a sample and hold circuit 112. The sample stored in the circuit 112 is applied to one input 114 of a differencing circuit 116, the other input 118 of which receives an analogue signal output by a digital-to-analogue converter 1 calibrated by a calibration circuit 60. The converter 1 and calibration circuit 60 are in accordance with Figs. 1 to 3 or Fig. 4. The differencing circuit 116 produces an analogue error signal which is applied to subsidiary analogue-to-digital converter 120 which converts this error signal to digital form and applies it to a successive approximation register 122. The successive approximation register outputs a digital word which is changed in accordance with a predetermined algorithm, in response to the value of the digital error signal produced by the subsidiary analogue-to-digital converter 120 and the previous digital word produced by the successive approximation register 122. The digital word output is applied to the digital-to-analogue converter 1. After a number of cycles, the algorithm reduces the error signal produced by the differencing circuit 116 to substantially zero. When this has been achieved, the number in the successive approximation register is a representation of the magnitude of the analogue input sample in circuit 112 and is applied to digital output 124. This output is more accurate than is obtained in prior ADC's due to the static accuracy of the calibrated DAC 1.

The speed at which analogue-to-digital converters can operate accurately is limited partly by the time taken for the signals generated within the circuit to settle down following each change. Thus, for example, each time a new sample is put into the sample and hold circuit 112, a finite time elapses before the circuit settles down to within one least significant bit of the equilibrium value and the sample can be measured. Further, each time the successive approximation register 122 generates a new binary number as the algorithm proceeds, which number is converted to analogue form by the calibrated DAC 1, a finite time is required for the circuit to settle down to within one least significant bit, when operation of the differencing circuit 116 can proceed. Noise is also present in the analogue circuit. Accordingly, as speed of operation is increased, or the number of bits is increased, the risk of errors in the analogue part of the circuit is increased. Error principally arises in the comparison taking place with the aid of the differencing circuit 116.

At each step in the successive approximation algorithm the differencing circuit 116 effectively takes a decision as to whether the analogue signal applied to input 118 is greater or less than that applied to input 114. If, for example, at a particular stage the differencing circuit 116 makes an error and indicates that the signal at input 118 is less than that at input 114, whereas in fact it is greater, the successive approximation algorithm will cause the register 122 to output a larger binary number to the converter 1 so as to increase the magnitude of the analogue signal produced thereby. Subsequently, due to the aforementioned error, the correct value for the digital signal cannot be recovered and it follows that unless the algorithm is repeated the particular sample stored in the circuit 112 at the time the error was made will never be converted to digital form.

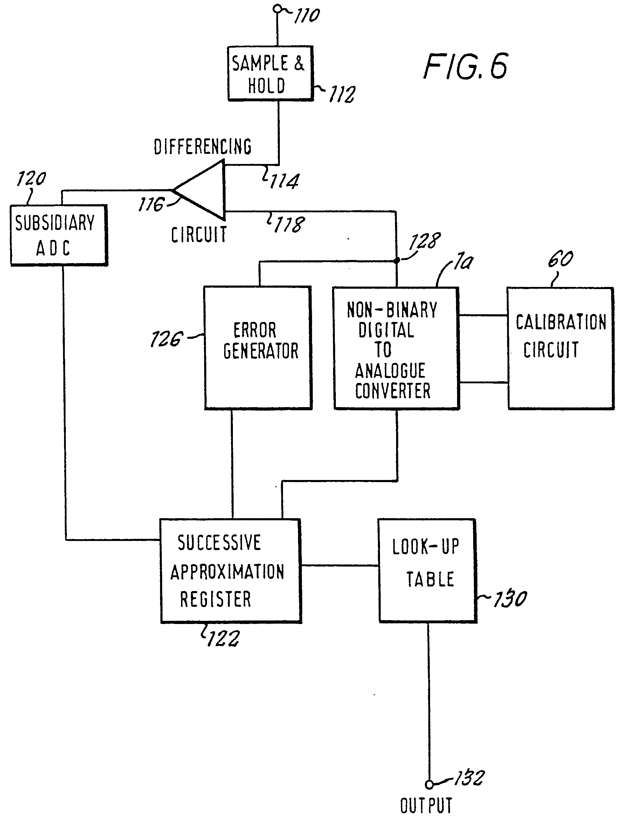

Fig. 6 shows an analogue-to-digital converter which is similar to that of Fig. 5 except that special provision is made to enable a digital signal to be produced correctly representing the value of the analogue sample despite the occurrence of an error such as that described above, without repeating the algorithm. Thus, in the arrangement of Fig. 6, the digital-to-analogue converter 1 is replaced by a digital-to-analogue converter 1a which is of similar construction except that the relative values of the resistors 28 in the current regulators are such that the ratio between the current produced by each regulator and that produced by the next regulator of lower significance is less than 2. The following Table IV shows a particular example of suitable current values:

### TABLE IV

| | 1st Bit | 2nd Bit | 3rd Bit | 4th Bit | 5th Bit | ... | Nth Bit |
|---|---|---|---|---|---|---|---|
| Current values $(i_n)$ | 1 | 0.6 | 0.36 | 0.216 | 0.1296 | | $(1/R)^{N-}$ |

In the above Table IV, the heading "1st Bit" indicates the current regulator corresponding to the most significant bit and the heading "Nth Bit" indicates the current regulator corresponding to the least significant bit. The Table IV assumes a current of value unity for the regulator corresponding to the most significant bit and indicates the appropriate values for each of the subsequent bits. The symbol R represents the ratio of the current produced by the regulator corresponding to the first bit to that produced by the regulator corresponding to the second bit. Accordingly, in the Example given in Table 4 above, R is 1:0.6 and the appropriate value of the current for the Nth bit is $(0.6)^{N-1}$.

On consideration of the above Table IV it can be seen that a current of the value produced by any of the current regulators of higher significance can be produced by summing the currents from several regulators of lower significance. Consequently, if an error as described above arises, a current of appropriate magnitude can still be produced later in the algorithm so that the correct value of the analogue signal stored in the circuit 112 can be determined without repeating the algorithm.

The error described above by way of example involved a wrong decision that the signal on input 118 was less than the signal on input 116 of the differencing circuit 116. Errors in the opposite sense may also be dealt with if, at each step in the algorithm, there is added to the output of the non-binary digital-to-analogue converter 1a an error current signal e having a value as shown in equation (1) below.

$$e = \frac{1}{2} \left[ \sum_{N}^{n+1} (i_N) - i_n \right] \tag{1}$$

In equation (1) N represents the bit produced by the successive approximation register at the step in the algorithm upon which a decision is currently being taken.

Thus, an error generator 126 receives signals from the successive approximation register 122 and generates an error current e in accordance with equation (1) at each step in the algorithm. The error current e is applied to a summing junction 128 at which it is summed with the output of the digital-to-analogue converter 1a.

In view of the non-binary relationship between the currents of the current regulators in the digital-to-analogue converter 1a, the digital number produced by the successive approximation register 122 at the time when the error produced by the differencing circuit 116 has been reduced to a value of substantially zero, is not a true representation of the value of the signal stored in circuit 112. A look-up table 130 is accordingly provided for converting the binary number produced by the register 122 at this time to a value which is a correct representation of the magnitude of the signal in circuit 112 and it is this converted binary signal which is applied to an output 132 of the circuit of Fig. 6.

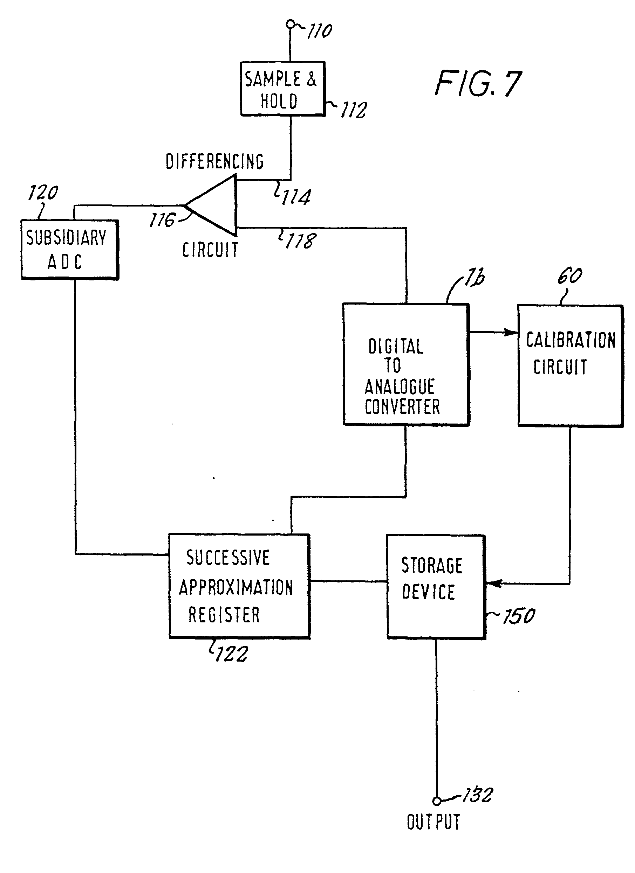

With reference to Fig. 7, in which the same reference numbers as used in Figs. 5 and 6 are used to indicate corresponding parts, a digital-to-analogue converter 1b, similar to that of Fig. 1 but without the voltage control circuit 63, is employed. This is initially set up to provide binary or slightly less than binary ratios between the values of the currents produced by the various regulators 20, 22 and 24. However, drift in these values is not compensated for by making adjustments in the current regulators 20, 22 or 24 as in Fig. 1 or otherwise, as for example shown in Fig. 4. Instead, the calibration circuit 60 applies data representing the relative magnitudes of the currents produced by the regulators 20, 22, 24 to a storage device 150 which stores in digital form the relative values of these currents. This data is continually updated to take account of drift. When the successive approximation register 122 produces a digital word which results in the signal output by the converter 1b being substantially equal to that stored in the sample and hold circuit 112, the device 150 produces a digital output based upon the sum of the appropriate stored values in the device 150. This sum may be computed in response to the production of the digital word in question by the register 122 or alternatively the device 150 may compute and store the sums of all possible combinations of the values of the current produced by the regulators 20, 22, 24 of the converter 1b so that these sum values are immediately available when the successive approximation algorithm is completed.

Various modifications are possible within the scope of the invention.

Although a preferred form of the calibration circuit has been illustrated in Fig. 2, other forms of calibration circuit may be employed as appropriate. Further, although one particular and preferred measurement routine for the calibration circuit shown in Fig. 2 has been illustrated with Fig. 3, other routines are possible.

In the circuit of Fig. 1 errors detected by the calibration circuit have been corrected by adjustment of the current regulators whereas in Fig. 4 such errors have been corrected by adding an analogue correction signal to the output of the converter. Other methods of correction are possible. For example, individual analogue correction signals could be added to the currents provided by the individual current regulators. Alternatively, a digital correction signal could be added to the digital word produced by the digital circuit 2. Further, where the digital-to-analogue converter is employed in an analogue-to-digital converter then by the correction could be made directly on the digital output of the analogue-to-digital circuit for example by adding an appropriate digital error signal to the output of the successive approximation register.

In the embodiment of Fig. 1, correction of the current through each current regulator is achieved by adjustment of the voltage applied to the amplifiers 44 and 46. Corrections to the currents could be achieved by other means. For example, correction resistances could be provided in each regulator which would be switched into or out of circuit as appropriate to correct for detected errors. Although it is preferred that the calibration circuit should be permanently connected to the digital-to-analogue converter so that calibration may be carried out continuously or at regular intervals, this is not essential.

Although the calibration circuit 60 illustrated in detail in Fig. 2 has only been shown in combination with the digital-to-analogue converter 1 or 1a, this calibration circuit may be used for measuring the outputs of other forms of digital-to-analogue converter.

Although Fig. 1 illustrates an arrangement in which corrections are applied to each of the three current regulators shown, since it is the ratio of the currents produced by the regulators which is important, it would be impossible within the scope of the invention to ignore errors in one of the currents and correct errors in the other currents to maintain the correct ratios between the currents.

Although Fig. 1 shows an arrangement in which the current regulators corresponding to only the three most significant bits of the binary number to be converted are calibrated, it would be possible, in accordance with the invention, to calibrate in the same way the current regulators corresponding to all of the bits of the binary number to be converted; or to fewer than three bits.

Although in the embodiment shown in Fig. 1 only two FETs 26 and 30 have been shown in the current regulator 20, it is possible to provide additional FETs in series with the resistor 28 for providing additional isolation. Further, it would be possible to use other forms of device instead of the FET's for controlling the current through the current regulator.

From the foregoing, it will be recognised that the invention provides substantial advantages. Of particular importance is the provision of a digital-to-analogue conversion circuit in which calibration can be achieved without interrupting the operation thereof. It is then possible to make a DAC substantially free of thermal drift and aging effects and thus accurate substantially above 16 bits.

## Claims

1. A digital-to-analogue converter which can be calibrated automatically and which has a plurality of weighted current sources (20, 22, 24), selection means (14, 16, 18) connected to one end (36) of said weighted current sources (20, 22, 24) and responsive to a digital word to be converted to analogue form for selecting said weighted current sources (20, 22, 24), summing means (4) for summing the currents from the selected weighted current sources (20, 22, 24) to provide an analogue output signal representing the digital word, and calibration means (60, 63) coupled to at least two of said weighted current sources (20, 22, 24) and arranged for performing a calibration operation in which said at least two sources (20, 22, 24) may be selected to provide a measurable current, the measurable current is measured and a correction is made to compensate at least partly for any errors in the measurable current, characterised by second selection means (56, 64, 66) connected to said at least two weighted current sources and controlled by said calibration means (60, 63, 70) to provide said measurable current independently of operation of the first-mentioned selection means so that calibration may be performed without interrupting the digital-to-analogue conversion.

2. A digital-to-analogue converter according to claim 1, characterised in that said second selection means is connected to said at least two weighted current sources (20, 22, 24) at the ends (42) thereof opposite to said one end (36) to which the first-mentioned selection means (14, 16, 18) is connected, and in that means (26, 30) is connected to each of said at least two weighted current sources (20, 22, 24) to maintain the currents provided thereby substantially invariant irrespective of selection thereof by either one or both of said selection means (14, 16, 18; 56, 64, 66).

3. A converter according to claim 2, characterised in that said at least two weighted current sources (20, 22, 24) are current regulators.

4. A converter according to claim 3, characterised in that each said current regulator comprises a first terminal (36) at which the weighted analogue current signal is provided, a second terminal (42) at which said measurable current is provided, and resistive means (28) connected between said terminals (36, 42), said means to maintain said currents invariant comprising first isolating means (26, 44) connected between said resistive means (28) and said first terminal (36), and second isolating means (30, 46) connected between said resistive means (28) and said second terminal (42).

5. A converter according to claim 4, characterised in that, in operation, current flows continuously through each said current regulator (20, 22, 24) regardless of whether it is selected by either or both or neither of said selection means.

6. A converter according to claim 4 or 5 characterised in that each said isolating (26, 44; 30, 46) means is voltage controlled.

7. A converter according to claim 6 characterised by a reference voltage source (50) connected between said isolating means (26, 44; 30, 46) to define the voltage maintained across said resistive means (28).

8. A converter according to claim 7 characterised in that each said isolating means comprises a field effect transistor (26; 30).

9. A converter according to claim 8 characterised in that each said isolating means includes an operational amplifier or a transconductive amplifier (44; 46) controlling the field effect transistor (26; 30) and said reference voltage is applied between one input of one of said amplifiers (44) and one input of the other of said amplifiers (46).

10. A converter according to any of claims 7 to 9 characterised in that said reference voltage source (50) is adjustable to provide adjustment of the voltage across said resistive means (28).

11. A converter according to any of claims 2 to 10 characterised in that said calibration means (63) is operable to adjust said at least two current sources (20, 22, 24) to effect said correction.

12. A converter according to claim 11 as dependent upon claim 11, characterised in that said calibration means (63) is operable to adjust said reference voltage source (50).

13. A converter according to claim 11 as dependent upon any of claims 4 to 11, characterised in that said calibration means is operable to adjust the value of said resistive means in circuit.

14. A converter according to any of claims 2 to 10, characterised in that said calibration means (100, 102) is operable to generate a correction analogue signal and to add said correction analogue signal into said analogue output signal.

15. A converter according to any of claims 2 to 14 characterised in that a measurement terminal (68) is arranged to sum the measurable currents from said at least two weighted current sources (20, 22, 24) when more than one thereof is selected by said second selection means simultaneously.

16. A converter according to claim 15 characterised in that said calibration means (60) is operable to perform a calibration operation in which a sequence of combinations of said measurable currents is summed at said measurement terminal (68) and measured to provide measurement data.

17. A converter according to claim 16 characterised in that said calibration means (60) is arranged to operate said second selection means (56, 64, 66, 70) to select a sqeuence of combinations of said measurable currents which produces at said terminal (68) a sum signal of staircase waveform, to subtract a ramp signal from said staircase waveform signal to produce a signal of sawtooth waveform and to obtain measurement data by measurement of times related to the length of the cycles of said sawtooth waveform.

18. A converter according to claim 17 characterised in that said calibration means (60) is effective to cause said staircase waveform to rise and to fall and to obtain said measurement data both during rising of the staircase waveform signal and during falling thereof.

19. A converter according to claim 17 or 18 characterised in that said calibration means (60) is operative to derive an indication of the current provided by each source from the measurement data obtained from measurement of a plurality of said times in each said sequence.

20. A converter according to any preceding claim characterised in that said weighting of said current sources (20, 22, 24) is such that the value of the current provided by each said source (apart from that of most significance) is substantially 0.5 that of the source of next most significance.

21. A converter according to any of claims 1 to 19 characterised in that the weighting of said current sources (20, 22, 24) is such that the value of the analogue current produced by each said source (apart for that of most significance) is greater than 0.5 of that of the source of next most significance.

22. A converter according to claim 21 wherein the ratios of the values of the currents produced by each pair of said sources of adjacent significance are the same.

23. An analogue-to-digital converter comprising means (112) for sampling an analogue signal to be converted to digital form; a digital-to-analogue converter (1, 1a, 1b) according to any of claims 1 to 22; a differencing circuit (116) providing a difference signal representing the difference between the sample in the sampling means (112) and the output of the digital-to-analogue converter (1, 1a, 1b) and means (120, 122) responsive to the difference signal for applying digital signals to the digital-to-analogue converter (1, 1a, 1b) in accordance with a successive approximation algorithm for reducing the magnitude of said difference signal and for providing a digital output.

24. An analogue-to-digital converter according to claim 23 as dependent upon claim 21 or 22 characterised by means (126, 130) to compensate for the ratio between the values of the analogue signals of adjacent significance being other than 0.5.

25. An analogue-to-digital converter according to claim 23 or 24 as dependent directly or indirectly on any of claims 16 to 20 as dependent in turn upon any of claims 1 to 10, characterised by means (150) which receives said measurement data from said calibration means (60) and which generates from said measurement data and in response to said digital output a digital signal representing said sample.

**Patentansprüche**

1. Digital-Analog-Umsetzer, der automatisch kalibriert werden kann und der aufweist: mehrere gewichtete Stromquellen (20, 22, 24), eine Auswahleinrichtung (14, 16, 18), die mit einem Ende (36) der gewichteten Stromquellen (20, 22, 24) verbunden ist und auf ein digitales Wort anspricht, das in analoge Form umgesetzt werden soll, um die gewichteten Stromquellen (20, 22, 24) auszuwählen, eine Summiereinrichtung (4) zum Summieren der Ströme von den ausgewählten gewichteten Stromquellen (20, 22, 24), um ein das digitale Wort repräsentierendes analoges Ausgangssignal zu liefern, und eine Kalibriereinrichtung (60, 63), die mit zumindest zwei der gewichteten Stromquellen (20, 22, 24) gekoppelt ist und angeordnet ist, um eine Kalibrieroperation durchzuführen, bei der diese zumindest zwei Quellen (20, 22, 24) ausgewählt werden können, um einen meßbaren Strom zu liefern, der meßbare Strom gemessen und eine Korrektur durchgeführt wird, um irgendwelche Abweichungen in dem meßbaren Strom zumindest teilweise zu kompensieren, gekennzeichnet durch eine zweite Auswahleinrichtung (56, 64, 66), die mit den zumindest zwei gewichteten Stromquellen verbunden ist und durch die Kalibriereinrichtung (60, 63, 70) gesteuert wird, um den meßbaren Strom unabhängig vom Betrieb der erstgenannten Auswahleinrichtung zu liefern, so daß die Kalibrierung durchgeführt werden kann, ohne die Digital-Analog-Umsetzung zu unterbrechen.

2. Digital-Analog-Umsetzer nach Anspruch 1, dadurch gekennzeichnet, daß die zweite Auswahleinrichtung mit den zumindest zwei gewichteten Stromquellen (20, 22, 24) an deren Enden (42) verbunden ist, gegenüber dem einen Ende (36), mit dem die erstgenannte Auswahleinrichtung (14, 16, 18) verbunden ist, und daß eine Einrichtung (26, 30) mit jeder der zumindest zwei gewichteten Stromquellen (20, 22, 24) verbunden ist, um die davon gelieferten Ströme unabhängig von deren Auswahl durch eine oder beide der Auswahleinrichtungen (14, 16, 18; 56, 64, 66) im wesentlichen unverändert zu halten.

3. Umsetzer nach Anspruch 2, dadurch gekennzeichnet, daß die zumindest zwei gewichteten Stromquellen (20, 22, 24) Stromregler sind.

4. Umsetzter nach Anspruch 3, dadurch gekennzeichnet, daß jeder der Stromregler aufweist: einen ersten Anschluß (36), an dem das gewichtete analoge Stromsignal geliefert wird, einen zweiten Anschluß (42), an dem der meßbare Strom geliefert wird, und eine Widerstandseinrichtung (28), die zwischen diese Anschlüsse (36, 42) geschlatet ist, wobei die Einrichtungen, um die Ströme unverändert zu halten, eine erste isolierende Einrichtung (26, 44), die zwischen die Widerstandseinrichtung (28) und den ersten Anschluß (36) geschaltet ist, sowie ein zweite isolierende Einrichtung (30, 46) aufweisen, die zwischen die Widerstandseinrichtung (28) und den zweiten Anschluß (42) geschaltet ist.

5. Umsetzer nach Anspruch 4, dadurch gekennzeichnet, daß beim Betrieb Strom kontinuierlich durch jeden Stromregler (20, 22, 24) fließt, unabhängig davon, ob er durch eine oder beide oder keine der Auswahleinrichtungen gewählt ist.

6. Umsetzer nach Anspruch 4 oder 5, dadurch gekennzeichnet, daß jede isolierende Einrichtung (26, 44; 30, 46) spannungsgesteuert ist.

7. Umsetzer nach Anspruch 6, gekennzeichnet durch eine Referenzspannungsquelle (50), die zwischen die isolierenden Einrichtungen (26, 44; 30, 46) geschaltet ist, um die über der Widerstandseinrichtung (28) gehaltene Spannung festzulegen.

8. Umsetzer nach Anspruch 7, dadurch gekennzeichnet, daß jede isolierende Einrichtung einen Feldeffekttransistor (26, 30) aufweist.

9. Umsetzer nach Anspruch 8, dadurch gekennzeichnet, daß jeder isolierende Einrichtung einen Operationsverstärker oder einen Steilheitsverstärker (44; 46) enthält, der den Feldeffekttransistor (26; 30) steuert, und daß die Referenzspannung zwischen einem Eingang von einem der Verstärker (44) und einem Eingang von dem anderen der Verstärker (46) angelegt wird.

10. Umsetzer nach einem der Ansprüche 7 bis 9, dadurch gekennzeichnet, daß die Referenzspannungsquelle (50) einstellbar ist, um für die Einstellung der Spannung über der Widerstandseinrichtung (28) zu sorgen.

11. Umsetzer nach einem der Ansprüche 2 bis 10, dadurch gekennzeichnet, daß durch die Kalibriereinrichtung (63) die zumindest zwei Stromquellen (20, 22, 24) eingestellt werden können, um die Korrektur durchzuführen.

12. Umsetzer nach Anspruch 11, soweit dieser von Anspruch 10 abhängig ist, dadurch gekennzeichnet, daß durch die Kalibriereinrichtung (63) die Referenzspannungsquelle (50) eingestellt werden kann.

13. Umsetzer nach Anspruch 11, soweit dieser von einem der Ansprüche 4 bis 10 abhängig ist, dadurch gekennzeichnet, daß durch die Kalibriereinrichtung der Wert der Widerstandseinrichtung in der Schaltung eingestellt werden kann.

14. Umsetzer nach einem der Ansprüche 2 bis 10, dadurch gekennzeichnet, daß durch die Kalibriereinrichtung (100, 102) ein analoges Korrektursignal erzeugt und dieses analoge Korrektursignal zu dem analogen Ausgangssignal addiert werden kann.

15. Umsetzer nach einem der Ansprüche 2 bis 14, dadurch gekennzeichnet, daß ein Meßanschluß (68) angeordnet ist, um die meßbaren Ströme von dem zumindest zwei gewichteten Stromquellen (20, 22, 24) zu summieren, wenn mehr als eine von ihnen gleichzeitig durch die zweite Auswahleinrichtung ausgewählt werden.

16. Umsetzer nach Anspruch 15, dadurch gekennzeichnet, daß durch die Kalibriereinrichtung (60) eine Kalibrieroperation durchgeführt werden kann, bei der eine Folge von Kombinationen der meßbaren Ströme an dem Meßanschluß (68) summiert und gemessen wird, um Meßdaten zu liefern.

17. Umsetzer nach Anspruch 16, dadurch gekennzeichnet, daß die Kalibriereinrichtung (60) angeordnet ist, die zweite Auswahleinrichtung (56, 64, 66, 70) so zu betätigen, daß sie eine Folge von Kombinationen der meßbaren Ströme auswählt, die an dem Anschluß (68) ein Summensignal mit Treppen-Wellenform erzeugt, ein Rampensignal von dem Treppen-Wellenformsignal zu subtrahieren, um ein Signal mit Sägezahn-Wellenform zu erzeugen, und durch Messung von Zeiten, die mit der Länge der Zyklen der Sägezahn-Wellenform korreliert sind, Meßdaten zu erhalten.

18. Umsetzer nach Anspruch 17, dadurch gekennzeichnet, daß die Kalibriereinrichtung (60) die Wirkung hat, das Ansteigen und Abfallen der Treppen-Wellenform zu veranlassen und die Meßdaten sowohl während des Ansteigens des Treppen-Wellenformsignals als auch während seines Abfallens zu erhalten.

19. Umsetzer nach Anspruch 17 oder 18, dadurch gekennzeichnet, daß durch die Kalibriereinrichtung (60) eine Angabe des von jeder Quelle gelieferten Stroms von den durch Messung einer Vielzahl der genannten Zeiten in jeder Folge erhaltenen Meßdaten abgeleitet werden kann.

20. Umsetzer nach einem der vorhergehenden Ansprüche, dadurch gekennzeichnet, daß die Gewichtung der Stromquellen (20, 22, 24) so ist, daß der Wert des von jeder Quelle (abgesehen von der mit der höchsten Wertigkeit) gelieferten Stroms im wesentlichen 0,5 von dem der Quelle mit der nächsthöchsten Wertigkeit beträgt.

21. Umsetzer nach einem der Ansprüche 1 bis 19, dadurch gekennzeichnet, daß die Gewichtung der Stromquellen (20, 22, 24) so ist, daß der Wert des von jeder Quelle (abgesehen von der mit der höchsten Wertigkeit) erzeugten analogen Stroms größer als 0,5 von dem der Quelle mit der nächsthöchsten Wertigkeit ist.

22. Umsetzer nach Anspruch 21, wobei die Verhältnisse der Werte der Ströme, die von jedem Paar der Quellen mit aufeinanderfolgender Wertigkeit erzeugt werden, gleich sind.

23. Analog-Digital-Umsetzer mit einer Einrichtung (112) zum Abtasten eines Analogsignals, das in digitale Form umgesetzt werden soll; einem Digital-Analog-Umsetzer (1, 1a, 1b) nach einem der Ansprüche 1 bis 22; einer Differenz-bildenden Schaltung (116), die ein Differenzsignal liefert, das die Differenz zwischen der Abtastprobe in der Abtasteinrichtung (112) und der Ausgabe des Digital-Analog-Umsetzers (1, 1a, 1b) wiedergibt; und einer Einrichtung (120, 122), die auf das Differenzsignal anspricht, um Digitalsignale an den Digital-Analog-Umsetzer (1, 1a, 1b) entsprechend einem Folge-Näherungsalgorithmus zur Verringerung der Größe des Differenzsignals und zur Lieferung einer digitalen Ausgabe anzulegen.

24. Analog-Digital-Umsetzer nach Anspruch 23, soweit dieser von Anspruch 21 oder 22 abhängig ist, gekennzeichnet durch Einrichtungen (126, 130), um das Verhältnis zwischen den Werten der analogen Signale mit aufeinanderfolgender Wertigkeit zu kompensieren, das nicht 0,5 beträgt.

25. Analog-Digital-Umsetzer nach Anspruch 23 oder 24, soweit sie direkt oder indirekt von einem der Ansprüche 16 bis 20 abhängig sind, soweit diese wiederum von einem der Ansprüche 1 bis 10 abhängig sind, gekennzeichnet durch eine Einrichtung (150), die die Meßdaten von der Kalibriereinrichtung (60) empfängt und die aus den Meßdaten und in Antwort auf die digitale Ausgabe ein die Abtastprobe repräsentierendes digitales Signal erzeugt.

**Revendications**

1. Un convertisseur numérique-analogique qui peut être étalonné automatiquement et qui comporte une pluralité de sources de courant pondéré (20, 22, 24), un moyen de sélection (14, 16, 18) relié à une extrémité (36) desdites sources de courant pondéré (20, 22, 24) et répondant à un mot numérique à convertir sous une forme analogique pour sélectionner lesdites sources de courant pondéré (20, 22, 24), un moyen de sommation (4) pour faire la sommation des courants provenant desdites sources de courant pondéré sélectionnées (20, 22, 24) afin de produire un signal de sortie analogique représentant le mot numérique, et des moyens d'étalonnage (60, 63) reliés à au moins deux desdites sources de courant pondéré (20, 22, 24) et agencés pour effectuer une opération d'étalonnage dans laquelle les au moins deux sources précitées (20, 22, 24) peuvent être sélectionnées pour produire un courant mesurable, le courant mesurable est mesuré et une corection est faite pour compenser au moins partiellement des erreurs dans le courant mesurable, caractérisé en ce qu'il est prévu un second moyen de sélection (56, 64, 66) relié auxdites au moins deux sources de courant pondéré et commandé par lesdits moyens d'étalonnage (60, 63, 70) pour produire ledit courant mesurable indépendamment d'un fonctionnement du moyen de sélection mentionné en premier de telle sorte qu'un étalonnage puisse être effectué sans interruption de la conversion numérique-analogique.

2. Convertisseur numérique-analogique selon la revendication 1, caractérisé en ce que ledit second moyen de sélection est relié auxdites au moins deux sources de courant pondéré (20, 22, 24) à leurs extrémités (42) opposées à l'extrémité précitée (36) à laquelle est relié le moyen de sélection (14, 16, 18) mentionné en premier et en ce qu'un moyen (26, 30) est relié à chacune desdites au moins deux sources de courant pondéré (20, 22, 24) afin de maintenir les courants fournis par celles-ci sensiblement invariants indépendamment de leur sélection par l'un ou l'autre ou bien les deux moyens de sélection précités (14, 16, 18; 56, 64, 66).

3. Convertisseur selon la revendication 2, caractérisé en ce que lesdites au moins deux sources de courant pondéré (20, 22, 24) sont des régulateurs de courant.

4. Convertisseur selon la revendication 3, caractérisé en ce que chaque régulateur de courant comprend une première borne (36) à laquelle est fourni le signal de courant analogique pondéré, une seconde borne (42) à laquelle ledit courant mesurable est fourni et un moyen résistif (28) connecté entre lesdites bornes (36, 42), ledit moyen servant à maintenir lesdits courants invariants comprenant un premier moyen d'isolation (26, 44) connecté entre ledit moyen résistif (28) et ladite première borne (36), et un second moyen d'isolation (30, 46) connecté entre ledit moyen résistif (28) et ladite seconde borne (42).

5. Convertisseur selon la revendication 4, caractérisé en ce que, en fonctionnement, du courant s'écoule de façon continue dans chaque régulateur de courant (20, 22, 24) indépendamment de ce qu'il soit sélectionné par l'un ou l'autre, ou bien les deux, ou bien aucun desdits moyens de sélection.

6. Convertisseur selon la revendication 4 ou 5, caractérisé en ce que, chacun desdits moyens d'isolation (26, 44; 30, 46) est commandé en tension.

7. Convertisseur selon la revendication 6, caractérisé en ce qu'une source de tension de référence (50) est connectée entre lesdits moyens d'isolation (26, 44; 30, 46) afin de définir la tension maintenue aux bornes dudit moyen résistif (28).

8. Convertisseur selon la revendication 7, caractérisé en ce que chaque moyen d'isolation comprend un transistor à effet de champ (26; 30).

9. Convertisseur selon la revendication 8, caractérisé en ce que chaque moyen d'isolation comprend un amplificateur opérationnel ou un amplificateur transconducteur (44; 46) commandant le transistor à effet de champ (26; 30) et ladite tension de référence est appliquée entre une entrée d'un des amplificateurs précités (44) et une entrée de l'autre amplificateur précité (46).

10. Convertisseur selon une quelconque des revendications 7 à 9, caractérisé en ce que ladite source de tension de référence (50) est réglable pour assurer un réglage de la tension aux bornes dudit moyen résistif (28).

11. Convertisseur selon une quelconque des revendications 2 à 10, caractérisé en ce que ledit moyen d'étalonnage (63) peut opérer pour régler lesdites au moins deux sources de courant (20, 22, 24) pour effectuer ladite correction.

12. Convertisseur selon la revendication 11, caractérisé en ce que ledit moyen d'étalonnage (63) peut opérer pour régler ladite source de tension de référence (50).

13. Convertisseur selon une quelconque des revendications 4 à 11, caractérisé en ce que ledit moyen d'étalonnage peut opérer pour régler la valeur dudit moyen résistif prévu dans le circuit.

14. Convertisseur selon une quelconque des revendications 2 à 10, caractérisé en ce que ledit moyen d'étalonnage (100, 102) peut opérer pour produire un signal analogique de correction et pour ajouter ledit signal analogique de correction audit signal analogique de sortie.

15. Convertisseur selon une quelconque des revendications 2 à 14, caractérisé en ce qu'une borne de mesure (68) est agencée pour additionner les courants mesurables provenant desdites au moins deux sources de courant pondéré (20, 22, 24) lorsque plus d'une source est sélectionnée simultanément par ledit second moyen de sélection.

16. Convertisseur selon la revendication 15, caractérisé en ce que ledit moyen d'étalonnage (60) peut opérer pour effectuer une opération d'étalonnage dans laquelle une séquence de combinaisons desdits courants mesurables est additionnée à ladite borne de mesure (68) et est mesurée pour produire une donnée de mesure.

17. Convertisseur selon la revendication 16, caractérisé en ce que ledit moyen d'étalonnage (60) est agencé pour activer ledit second moyen de sélection (56, 64, 66, 70) afin de sélectionner une séquence de combinaisons desdits courants mesurables qui produise à ladite borne (68) un signal de sommation ayant une forme d'onde en escalier, pour soustraire un signal en rampe du signal à forme d'onde en escalier afin de produire un signal à former d'onde en dents de scie, et pour obtenir une donnée de mesure par une mesure des temps se rapportant à la durée des cycles de ladite forme d'onde en dents de scie.

18. Convertisseur selon la revendication 17, caractérisé en ce que ledit moyen d'étalonnage (60) agit de façon à produire une croissance et une décroissance de la forme d'onde en escalier et à obtenir ladite donnée de mesure à la fois pendant la croissance du signal à forme d'onde en escalier et pendant sa décroissance.

19. Convertisseur selon la revendication 17 ou 18, caractérisé en ce que ledit moyen d'étalonnage (60) opère de façon à dériver une indication du courant fourni par chaque source à partir de la donnée de mesure obtenue par une mesure d'une pluralité desdits temps dans chacune desdites séquences.

20. Convertisseur selon une quelconque des revendications précédentes, caractérisé en ce que ladite pondération desdites sources de courants (20, 22, 24) est telle que la valeur du courant fourni par chacune desdites sources (mise à part celle de capacité maximale) soit sensiblement la moitié de celle de la source de capacité immédiatement suivante.

21. Convertisseur selon une quelconque des revendications 1 à 19, caractérisé en ce que la pondération desdites sources de courants (20, 22, 24) est telle que la valeur du courant analogique produit par chacune desdites sources (mise à part celle ayant la capacité maximale) soit supérieure à la moitié de celle de la source de la capacité immédiatement suivante.

22. Convertisseur selon la revendication 21, caractérisé en ce que les rapports des valeurs des courants produits par chaque paire desdites sources de capacités adjacentes sont les mêmes.

23. Convertisseur analogique-numérique comprenant un moyen (112) pour échantillonner un signal analogique à convertir sous une forme numérique; un convertisseur numérique-analogique (1, 1a, 1b) correspondant à l'une quelconque des revendications 1 à 22; un circuit de différenciation (116) produisant un signal de différence représentant la différence entre l'échantillon existant dans le moyen d'échantillonnage (112) et le signal de sortie du convertisseur numérique-analogique (1, 1a, 1b) et des moyens (120, 122) répondant au signal de différence pour appliquer des signaux numériques au convertisseur numérique-analogique (1, 1a, 1b) en concordance avec un algorithme d'approximation successive en vue de réduire la grandeur dudit signal de différence et de fournir un signal numérique de sortie.

24. Convertisseur analogique-numérique selon une des revendications 21 à 23, caractérisé par des moyens (126, 130) pour compenser le rapport entre les valeurs des signaux analogiques de capacités adjacentes lorsqu'il est différent de 0,5.

25. Convertisseur analogique-numérique selon une des revendications 23 ou 24, dépendant directement ou indirectement de l'une quelconque des revendications 16 à 20, dépendant à leur tour de l'une quelconque des revendications 1 à 10, caractérisé par un moyen (150) qui reçoi ladite donnée de mesure provenant dudit moyen d'étalonnage (60) et qui produit à partir de cette donnée de mesure et en réponse audit signal numérique de sortie un signal numérique représentant ledit échantillon.

## FIG.1

## FIG. 2

FROM 68

60

CLOCK 88

74

76

82

78

80

REVERSIBLE
CURRENT
SOURCE

92 90 86 84

DATA
STORE

COUNTER

COMPARATOR

72

PROCESSOR

TO 63 and 70

FIG.3

EP 0 070 086 B1

## FIG. 4

*FIG.5*

FIG.6

FIG. 7